Europäisches Patentamt

European Patent Office

Office européen des brevets

(11) Numéro de publication: **0 322 062**
**A1**

## (12) DEMANDE DE BREVET EUROPEEN

(21) Numéro de dépôt: 88202947.3

(22) Date de dépôt: 19.12.88

(51) Int. Cl.⁴: **G01S 13/28 , G01S 7/28 , H03B 9/14**

(30) Priorité: 23.12.87 FR 8718047

(43) Date de publication de la demande:
28.06.89 Bulletin 89/26

(84) Etats contractants désignés:
**DE GB IT NL**

(71) Demandeur: **N.V. Philips'
Gloeilampenfabrieken
Groenewoudseweg 1
NL-5621 BA Eindhoven(NL)**

(72) Inventeur: **Zilliox, Jean-Marie Société Civile
S.P.I.D.
209, rue de l'Université
F-75007 Paris(FR)**

(74) Mandataire: **Pyronnet, Jacques et al
Société Civile S.P.I.D. 209 rue de l'Université
F-75007 Paris(FR)**

(54) Radar à compression d'impulsions et application à la cartographie ou à la météorologie.

(57) Le radar, du type à modulation quasi-linéaire de la fréquence du signal émis pendant l'impulsion, comporte une chaîne d'émission munie d'un oscillateur à haute fréquence (29), une antenne émettrice-réceptrice (7) et une chaîne de réception munie d'un organe de compression d'impulsions (33). Selon l'invention, dans la chaîne d'émission, une diode Impatt (17) d'un combineur à une diode (16) engendre directement en hyperfréquence un signal de synchronisation de l'oscillateur (impulsions modulées selon des rampes négatives de fréquence). A cet effet, un générateur d'horloge (26) commande en conduction, pour chaque impulsion à émettre, un interrupteur (25) disposé en série sur le conducteur (19) d'alimentation à courant sensiblement constant de la diode Impatt (17).

Application à la cartographie ou à la météorologie.

FIG.3

## Radar à compression d'impulsions et application à la cartographie ou à la météorologie

L'invention concerne un radar à compression d'impulsions du type à modulation quasi-linéaire de la fréquence du signal émis pendant l'impulsion, comportant une chaîne d'émission munie d'un oscillateur-amplificateur à haute fréquence, une antenne émettrice-réceptrice et une chaîne de réception munie d'un organe de compression d'impulsions.

Les radars à compression d'impulsions ont de multiples applications. Ils fonctionnent pour la plupart en bande X et peuvent être disposés au sol ou aéroportés. Dans ce dernier cas, ils servent notamment à la surveillance maritime, à la cartographie, à la météorologie.

Dans ces radars, on utilise couramment comme oscillateur-amplificateur à haute fréquence, dans la chaîne d'émission, c'est-à-dire comme source de puissance, des tubes à onde progressive. Il est aussi possible d'utiliser des sources à l'état solide à diodes Impatt.

Le principe des radars à compression d'impulsions est bien connu et décrit par exemple dans Techniques de l'ingénieur, Electronique, tome 5, E 6660-1,24. Par comparaison avec le radar en impulsion classique, le radar à compression d'impulsions permet de conserver l'indépendance entre la durée T et la bande $\Delta f$ du signal, ce qui conduit à la notion de taux de compression : $T.\Delta f$. D'un point de vue pratique, ceci signifie qu'à puissance égale des deux types de radars précités, la portée et la définition du radar à compression d'impulsions sont améliorées dans le rapport du taux de compression par rapport au radar en impulsion de même puissance. Cet avantage primordial s'obtient moyennant une complication du système de radar. A partir d'un radar en impulsion classique à amplification de puissance, il faut placer après le découpeur du signal d'émission à fréquence intermédiaire un filtre $\gamma(f)$ qui déphase différemment les diverses fréquences du spectre du signal émis et, à la réception, après le changement de fréquence, un filtre $\gamma^*(f)$ qui a pour effet de compenser les déphasages apportés par le filtre $\gamma(f)$. Tous les procédés pratiques se ramènent à utiliser, pour l'expansion des impulsions, une modulation linéaire, ou quasi-linéaire, de la fréquence du signal émis, suivie à la réception d'une modulation linéaire de la fréquence en sens inverse. On notera que la chaîne d'émission ainsi obtenue est complexe puisqu'elle comporte, en amont de l'oscillateur-amplificateur en hyperfréquence, les éléments suivants disposés en cascade : un premier oscillateur local OL1 qui engendre la fréquence intermédiaire, un découpeur pour la conformation des impulsions émises en fréquence intermédiaire, le filtre $\gamma(f)$ toujours en fréquence intermédiaire et un mélangeur qui reçoit sur une deuxième entrée le signal d'un deuxième oscillateur local OL2. Par ailleurs, lorsqu'on souhaite modifier les caractéristiques du radar à compression d'impulsions de l'art antérieur il est nécessaire de changer les deux filtres $\gamma(f)$ et $\gamma^*(f)$ qui doivent rester adaptés l'un à l'autre. Diverses techniques ont été tour à tour utilisées pour fabriquer les fitres $\gamma(f)$ et $\gamma^*(f)$ : filtres à constante répartie, filtres à ondes acoustiques, lignes à quartz à onde de volume et, plus récemment des lignes à transducteurs en peigne à onde de surface ou des lignes en analogique échantillonnné. Pour la génération du signal en impulsion à haute fréquence et à bas niveau de puissance, il n'est pas toujours nécessaire d'utiliser une ligne dispersive au titre du filtre $\gamma(f)$, la génération pouvant aussi être directe, telle qu'une commande d'oscillateur. Cependant, même dans ce dernier cas, l'oscillateur fonctionne en fréquence intermédiaire et le système obtenu reste complexe, donc cher.

Un but de la présente invention est de mettre à profit la dérive en température d'une diode Impatt fonctionnant en impulsion, qui engendre une décroissance sensiblement linéaire de la fréquence du signal émis par la diode pendant la durée de l'impulsion.

Un autre but de l'invention est d'engendrer directement un signal en impulsion à haute fréquence et à niveau moyen qui présente dans l'impulsion une variation linéaire, ou quasi-linéaire de la fréquence.

Encore un autre but de l'invention est de réaliser un radar à compression d'impulsions de conception simple, dans lequel le signal de synchronisation de l'oscillateur-amplificateur en hyperfréquence est obtenu directement en hyperfréquence.

Encore un autre but de l'invention est de limiter à un minimum, dans la chaîne d'émission, les organes fonctionnant en fréquence intermédiaire et en hyperfréquences dans un radar à compression d'impulsions.

Encore un autre but de l'invention est de réaliser un radar simple et fiable pour faire de la cartographie et/ou pour des applications météorologiques.

Selon l'invention ces buts sont atteints et les inconvénients de l'art antérieur sont atténués grâce au fait que le radar défini au premier paragraphe de la description est remarquable en ce que dans la chaîne d'émission une diode Impatt d'un combineur à une diode engendre directement en hyperfréquence un signal de synchronisation dudit oscillateur-amplificateur consistant en des impulsions modulées selon des rampes négatives de fréquence, qu'un circuit d'alimentation alimente ladite diode Impatt sous un courant sensiblement constant et qu'un générateur d'horloges commande, pour la génération de chaque impulsion d'émission successivement la fermeture puis l'ouverture d'un interrupteur disposé en série sur le conducteur d'alimentation de ladite diode Impatt.

Lorsqu'on étudie le fonctionnement d'un combineur à diodes Impatt, on constate que lorsque le combineur n'est pas synchronisé, par absence de signal de synchronisation dans la cavité résonnante du combineur, le spectre est très large et ne ressemble pas à un spectre d'impulsions de largeur T à fréquence constante dans l'impulsion et de fréquence de répétition d'impulsions FR. Ceci est dû au fait que dans l'impulsion il y a une variation de fréquence due à l'élévation de la température de jonction de la diode. Si un combineur à diodes Impatt est utilisé comme source de puissance dans un radar en impulsion classique, il s'agit là d'un défaut et il convient, pour supprimer ce défaut, soit de synchroniser le combineur à diodes par un signal en hyperfréquence à fréquence constante, soit de modifier la forme du courant modulateur dans les diodes Impatt de façon à compenser la variation parasite de fréquence. Si l'on mesure la variation de fréquence dans l'impulsion on constate que, abstraction faite des premières et des dernières microsecondes en début et en fin d'impulsion, la variation de fréquence est pratiquement linéaire, pour un courant modulateur constant dans l'impulsion. L'idée de base de l'invention est de mettre à profit cette particularité de fonctionnement d'une diode Impatt dans un combineur à diodes en utilisant directement le signal de sortie d'un combineur à une diode Impatt comme signal de synchronisation de la source de puissance dans un radar à compression d'impulsions. Comme déjà indiqué ci-dessus, la source de puissance en question peut être notamment un tube à ondes progressives ou un combineur à diodes Impatt. Les tubes à ondes progressives (T.O.P.) utilisés surtout dans les radars aéroportés peuvent fournir une puissance allant jusqu'à 10 kW crête, pour des largeurs d'impulsions comprises entre quelques dixièmes de microsecondes et quelques dizaines de microsecondes, avec des rapports cycliques d'environ 2%. A ces puissances élevées les T.O.P. sont alimentés par des tensions et des courants respectivement d'environ 12500 V et 2,5 A et leur masse est en proportion de leur puissance élevée. Il existe cependant des T.O.P. de puissance plus faible de l'ordre de 1 kW, plus appropriés à la mise en oeuvre de la présente invention. De préférence, on utilise comme source de puissance dans le radar selon l'invention des composants actifs constitués par des diodes Impatt à l'arséniure de gallium regroupés en un ou plusieurs combineurs à diodes, ce qui permet d'obtenir des puissance crêtes de l'ordre de une à quelques centaines de watts crête, les caractéristiques de largeur d'impulsion, et de rapport cyclique étant comparables à celles des T.O.P. précités. Dans de tels combineurs à diodes, chaque diode Impatt est alimentée par un circuit d'alimentation à courant constant pendant l'impulsion, ce courant étant de l'ordre de 1 A et des interrupteurs sont disposés en série sur les conducteurs d'alimentation des diodes.

Si l'on s'en tient à un signal de synchronisation obtenu directement en sortie de la diode Impatt du combineur à une diode alimentée à courant constant, les défauts de linéarité de la courbe F(t) de ce signal peuvent être gênants pour certaines applications surtout à cause de lobes secondaires d'un niveau trop élevé que cela entraîne à la réception.

En conséquence, un premier mode de réalisation de l'invention visant à améliorer la linéarité en fréquence du signal d'émission du radar à compressionn d'impulsions est remarquable en ce que ledit circuit d'alimentation comporte un modulateur de courant réglé pour engendrer dans ladite diode Impatt, pendant la durée de l'impulsion, un courant modulé qui compense au moins au premier ordre les défauts de linéarité dudit signal de synchronisation.

Un deuxième mode de réalisation du radar selon l'invention muni d'un combineur à diodes comme source de puissance, compatible avec le précédent, est remarquable en ce que le même signal d'horloge commande à la fois l'interrupteur d'alimentation de la diode Impatt du combineur à une diode et les interrupteurs d'alimentation des diodes du combineur à diodes.

Un troisième mode de réalisation du radar selon l'invention muni d'un combineur à diodes comme source de puissance est remarquable en ce qu'il comporte en outre dans la chaîne d'émission entre ledit combineur à une diode et ledit combineur à diodes un interrupteur pour hyperfréquences qui est commandé en conduction à partir dudit générateur d'horloges ainsi que les interrupteurs d'alimentation des diodes dudit combineur à diodes selon une première durée d'impulsion utile, et que l'interrupteur d'alimentation de la diode Impatt dudit combineur à une diode est commandé en conduction à partir dudit générateur d'horloges selon une deuxième durée qui contient ladite première durée, pour la génération de chaque impulsion d'émission. De préférence, l'interrupteur pour hyperfréquences est constitué par une diode PIN commandée à l'ouverture et à la fermeture par un signal de tension logique issu du générateur d'horloges. Ce mode de réalisation permet de sélectionner dans l'impulsion de sortie du combineur à une diode Impatt, à titre de signal de synchronisation, seulement la partie centrale de l'impulsion qui présente la meilleure linéarité de fréquence en fonction du temps sous la forme d'une rampe négative de fréquence.

La description qui suit en regard des dessins annexés, le tout donné à titre d'exemple, fera bien comprendre comment l'invention peut être réalisée.

La figure 1 est un schéma synoptique d'un radar à compression d'impulsions selon l'art antérieur.

La figure 2a est le schéma synoptique d'un combineur à une diode Impatt muni d'un circuit d'alimentation et d'un interrupteur sur le conducteur d'alimentation.

La figure 2b représente la courbe de réponse de fréquence en fonction du temps F(t) du combineur de la figure 2a dont la diode Impatt est alimentée à courant constant.

La figure 3 est le schéma synoptique d'un premier mode de réalisation du radar à compression d'impulsions selon l'invention.

La figure 4 est le schéma synoptique d'un deuxième mode de réalisation du radar à compression d'impulsions selon l'invention.

La figure 5 est le schéma synoptique d'un troisième mode de réalisation du radar à compression d'impulsions selon l'invention.

La figure 6a représente différentes positions dans le temps d'une première durée d'impulsion utile à l'intérieur d'une deuxième durée d'impulsion en sortie de l'oscillateur à une diode Impatt et les figures 6b, 6c, 6d et 6e les spectres des signaux hyperfréquences correspondants.

La figure 7 est une vue en perspective en partie arrachée d'une antenne à fentes supportant les circuits hyperfréquences du radar selon l'invention.

Les figures 8a, 8b, 8c, 8d, 8f sont des diagrammes de temps et la figure 8e est un spectre, servant à expliciter le fonctionnement du radar à compression d'impulsions selon l'invention.

Sur les figures, les mêmes références représentent les mêmes éléments avec les mêmes fonctions.

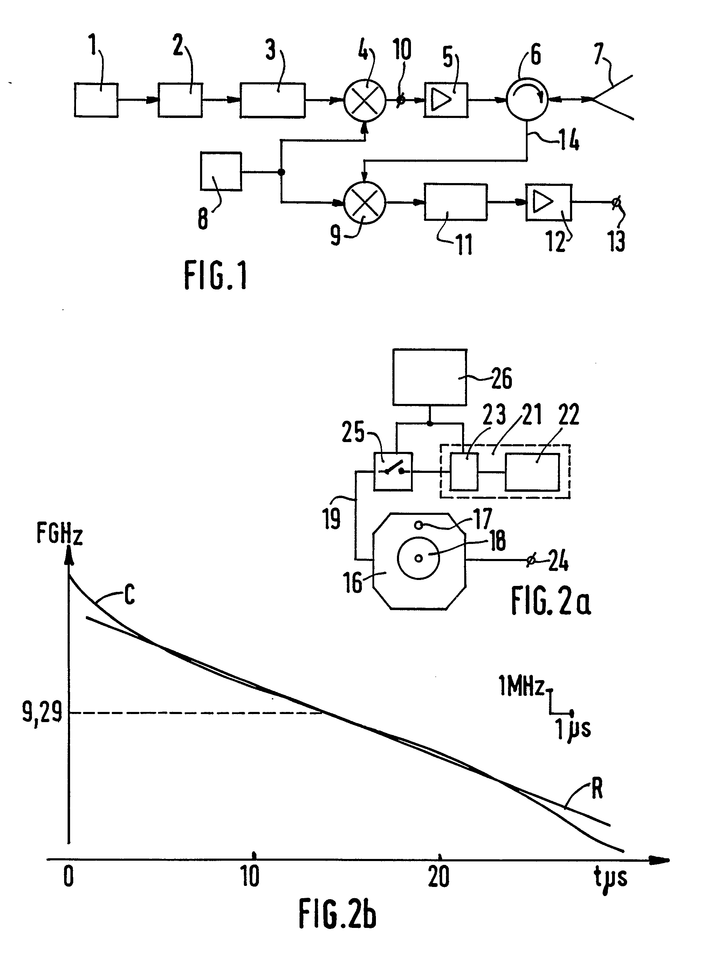

Un radar à compression d'impulsions connu tel que représenté à la figure 1 comporte en cascade dans la chaîne d'émission : un premier oscillateur local 1, un découpeur 2 et un filtre 3, qui fonctionnent en fréquence intermédiaire, puis un premier mélangeur 4, une source de puissance 5, un duplexeur 6 et une antenne 7 qui fonctionnent en hyperfréquence. L'oscillateur local 1 fournit un signal de fréquence intermédiaire par exemple à 30 MHz. Ce signal est découpé par le découpeur 2 en impulsions de durée comprise entre quelques dixièmes et quelques dizaines de microsecondes, par exemple 10 μs, avec un rapport cyclique de préférence inférieur à 3% et typiquement égal à 1%. Le filtre 3 réalise une expansion temporelle de chaque impulsion ; en pratique, le filtre 3 engendre, dans l'impulsion, une rampe de fréquence à pente positive ou négative. Pour fixer les idées, on suppose que le filtre 3 est constitué par une ligne à transducteurs en peigne à onde de surface engendrant des rampes négatives de fréquence avec une excursion en fréquence par exemple égale à 3 MHz. Le mélangeur 4 effectue un battement additif entre le signal de sortie du filtre 3 et un deuxième oscillateur local 8 qui engendre un signal hyperfréquences par exemple à 9 GHz. Le signal de sortie du mélangeur 4, sur la borne 10, est constitué par des impulsions en hyperfréquences (9 GHz) à bas niveau de puissance, présentant une variation linéaire à pente négative de fréquence dans l'impulsion (3 MHz en 10 μs). Ce signal est amplifié en hyperfréquences par la source de puissance 5, par exemple un T.O.P., pour fournir un signal de puissance par exemple égale à 1 kW crête, ou un combineur à diodes Impatt pour fournir un signal de puissance typiquement égale à 100 W crête. Ce dernier signal de puissance traverse le duplexeur 6, par exemple un circulateur, puis est émis par l'antenne émettrice-réceptrice 7.

La chaîne de réception comporte en cascade l'antenne 7, le duplexeur 6, un deuxième mélangeur 9, un organe de compression d'impulsions (filtre) 11, un amplificateur 12 et la borne de sortie 13. Le signal d'écho à bas niveau de puissance constitué par des impulsions expansées en hyperfréquences est capté par l'antenne 7, traverse le circulateur 6 et, à partir d'une deuxième sortie 14 de ce dernier, est transmis au mélangeur 9 qui effectue un battement soustractif entre le signal d'écho et le deuxième signal d'oscillation locale hyperfréquence. On obtient ainsi en sortie du mélangeur 9 un signal comparable au signal de sortie du filtre 3. Le signal à fréquence intermédiaire traverse ensuite l'organe 11 qui a une fonction de transfert pratiquement inverse de celle du fitre 3. L'organe 11 est par exemple une ligne à transducteurs en peigne à onde de surface ; de préférence l'organe 11 intègre, de façon connue, un filtrage visant à atténuer le niveau des lobes secondaires pour les rabaisser de -13,5 dB à -30 dB environ par rapport au lobe principal. Ceci constitue une pondération obtenue par une légère désadaptation du filtre 11 en lui donnant une loi de transmittance non rectangulaire, ce qui provoque un léger élargissement du signal (10 à 20%) et une légère perte de filtrage (1 dB). Le signal est ensuite amplifié dans l'amplificateur 12 et fourni par ce dernier à titre de signal utile sur la borne de sortie 13.

Dans le radar à compression d'impulsions selon l'invention, les éléments 5 à 13 de la figure 1 sont conservés et les éléments 1 à 4 sont remplacés par le circuit de la figure 2a.

Sur le schéma de la figure 2a est représenté un circuit combineur à une diode (combineur à une diode) 16 comportant une diode Impatt 17. Le combineur 16 est muni d'une cavité 18 et constitue un résonateur. La diode Impatt est alimentée, par l'intermédiaire du conducteur 19, par un circuit d'alimentation 21

4

constitué lui-même d'un générateur de tension 22 et d'un modulateur 23. Pour produire sur la borne de sortie 24 un signal sous forme d'impulsions en hyperfréquence, un circuit interrupteur (interrupteur) 25 est disposé en série sur le conducteur 19. L'ouverture et la fermeture de l'interrupteur 25 sont commandées par un signal de tension logique issu d'un générateur d'horloges 26 ; le même signal d'horloge commande aussi le modulateur 23.

Les combineurs à diodes(s) Impatt sont bien connus dans la technique des oscillateurs à haute fréquence. De préférence le combineur 16 est circulaire, c'est-à-dire que sa cavité 18 est cylindrique comme décrit par exemple dans le brevet US 3 931 587 en ce qui concerne le principe de fonctionnement. La diode Impatt 17 est par exemple une diode MA 46045 fabriquée par la société américaine MACOM, qui est alimentée par un courant compris entre 0,8 et 1,2 A et peut fournir une puissance crête de 12,5 W. La fréquence d'oscillation choisie, qui correspond à un mode possible, parmi plusieurs modes, déterminée par la cavité et l'adaptation à cette cavité, est par exemple égale à 9300 MHz. On peut aussi choisir une diode Impatt présentant des performances comparables produite par la société américaine VARIAN ou par la société japonaise NEC.

Pour obtenir la forme de courant désirée dans la diode Impatt 17 le générateur de tension 22 fournit au modulateur 23 un signal de tension de l'ordre de 60 à 80 V. Le modulateur 23 est de préférence constitué par un ensemble de transistors fonctionnant en amplification et recevant sur leur base des signaux de commande logique à partir du signal de commande en provenance du générateur d'horloges 26. L'interrupteur 25 est, de préférence, constitué par un transistor à effet de champ V.MOS commandé par un signal de tension logique sur sa grille.

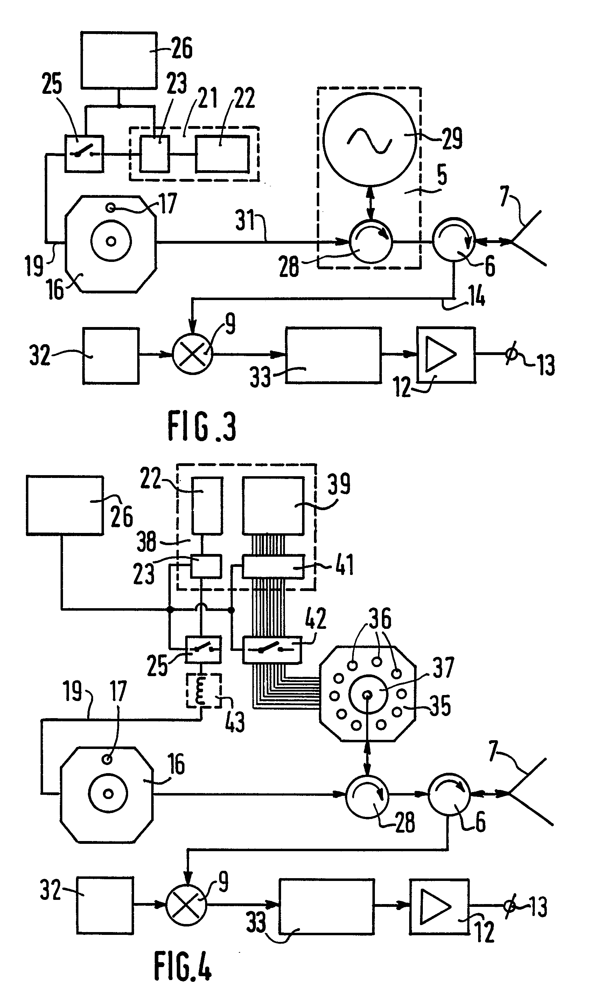

Le modulateur 23 est normalement conçu pour fournir un courant constant, par exemple de 1 A à la diode Impatt 17, de façon à constituer une source de courant, pendant la durée de chaque impulsion. Lorsqu'un courant constant est injecté dans une diode Impatt du type précité monté dans un combineur à diode 16, la courbe de réponse de fréquence en fonction du temps sur la borne de sortie 24, F(t), pour une impulsion de largeur maximale de 32 $\mu$ permise par la diode est telle que représentée par C à la figure 2b. La courbe C est assimilable en première approximation à une rampe négative de fréquence, R, de pente : 0,302 Mhz/$\mu$s, autour de 9290 MHz, soit par exemple 2,4 MHz en 8 $\mu$s. La courbe C est obtenue pour un courant constant de 0,85 A environ et affecte la forme d'un S très allongé autour de la droite R, les parties les plus aberrantes de la courbe C par rapport à la rampe R étant celle qui correspond aux trois premières microsecondes de l'impulsion et, pour une impulsion de longue durée, la partie située au-delà de 26 $\mu$s après le début de l'impulsion. La zone pratiquement linéaire s'étend donc sur environ 20 $\mu$s avec une excursion de fréquence $\Delta$F correspondante d'environ 6 MHz. La courbe théorique de réponse en fréquence normalement souhaitée en sortie du combineur à une diode 16 est une droite horizontale, c'est-à-dire une constante en fonction du temps. L'aspect de la courbe C qui apparaît comme un défaut pour la plupart des applications de ces diodes résulte d'une dérive en température de la diode, liée à l'élévation rapide de la température de jonction de la diode pendant l'impulsion. En l'occurrence cette variation négative quasi-linéaire est mise à profit pour engendrer la forme de signal souhaité pour un radar à compression d'impulsions étant donné par ailleurs que les valeurs d'excursion $\Delta$F obtenues conviennent et que la jonction de la diode Impatt 17 a un temps suffisant pour se refroidir entre deux impulsions, étant donnés les rapports cycliques pratiqués, compris entre 1% et 3%. Pour un courant modulateur de 1,2 A au lieu de 0,85 A, l'excursion de fréquence $\Delta$F est d'environ 10 MHz sur la même durée, la forme de la courbe C demeurant sensiblement la même.Lorsqu'on utilise le signal sur la borne 24 comme signal de synchronisation de la source de puissance 5, figure 1, c'est-à-dire lorsqu'on connecte les bornes 10 et 24, les éléments 1 à 4 étant supposés absents, on obtient le radar selon l'invention sous sa forme d'exécution la plus simple et la plus générale comme représenté à la figure 3. Les valeurs numériques relatives à la courbe C qui sont indiquées ci-dessus impliquent qu'un taux de compression T.$\Delta$F de l'ordre de 200 est envisageable pour le radar à compression selon l'invention.

Sur la figure 3 la source de puissance 5 est schématisée sous la forme d'un circulateur 28 relié à un oscillateur-amplificateur 29 qui est de préférence un combineur à diodes Impatt. On notera que le signal de synchronisation de l'oscillateur 29, sur le conducteur 31, est obtenu directement en hyperfréquence, ce qui simplifie beaucoup la chaîne d'émission du radar. L'oscillateur local, à la réception, référencé 32 fournit un signal dont la fréquence constante est, de préférence, inférieure à la fréquence du signal d'écho en impulsions fourni à l'entrée du mélangeur 9. Par exemple, l'oscillateur local 32 fournit un signal de fréquence 9260 MHz et le mélangeur 9 opère un battement soustractif entre la fréquence du signal d'écho (fréquence moyenne de 9290 MHZ) et la fréquence constante de 9260 MHz. Le mélangeur 9 fournit donc à sa sortie un signal en impulsions dont la fréquence est égale à la différence entre celle du signal d'écho et celle du signal issu de l'oscillateur local 32. L'organe de compression d'impulsions, référencé 33, doit avoir une fonction de transfert inverse de celle du combineur à diodes 16. En association avec la diode Impatt 17 choisie précitée, l'organe 33 est par exemple une ligne à transducteurs en peigne à ondes de surface, modèle DS-30-3,6-8-131 A fabriquée par la société américaine ANDERSEN LABORATORIES. Cette ligne, qui intègre une pondération visant à rabaisser le niveau des lobes secondaires, a les caractéristiques suivantes :

| fréquence centrale : | 30 MHz |
|---|---|
| bande passante : | 3,6 MHz |
| dispersion : | 8 μs |
| pondération : | ≤ 32 dB |
| pente : | positive |
| insertion : | ≤ 30 dB |
| impulsion comprimée : | ≈ 400 ns |
| dimensions : | 5,05 x 2,51 x 058 cm. |

L'organe 33 peut aussi être conçu spécialement pour le radar de la figure 3, ce qui signifie plus précisément que sa fonction de transfert peut prendre en compte les non-linéarités de la courbe C, figure 2b, de façon à les compenser, en association avec le rabaissement des lobes secondaires, toujours souhaitable. On notera à ce sujet que la ligne ANDERSEN précitée rabaisse les lobes secondaires à -32 dB.

Le radar de la figure 3 convient pour des applications pour lesquelles des performances moyennes sont requises avec cependant une définition et une portée améliorées sensiblement dans le rapport du taux de compression par rapport à un radar en impulsion non comprimée classique, à haute fréquence comparable.

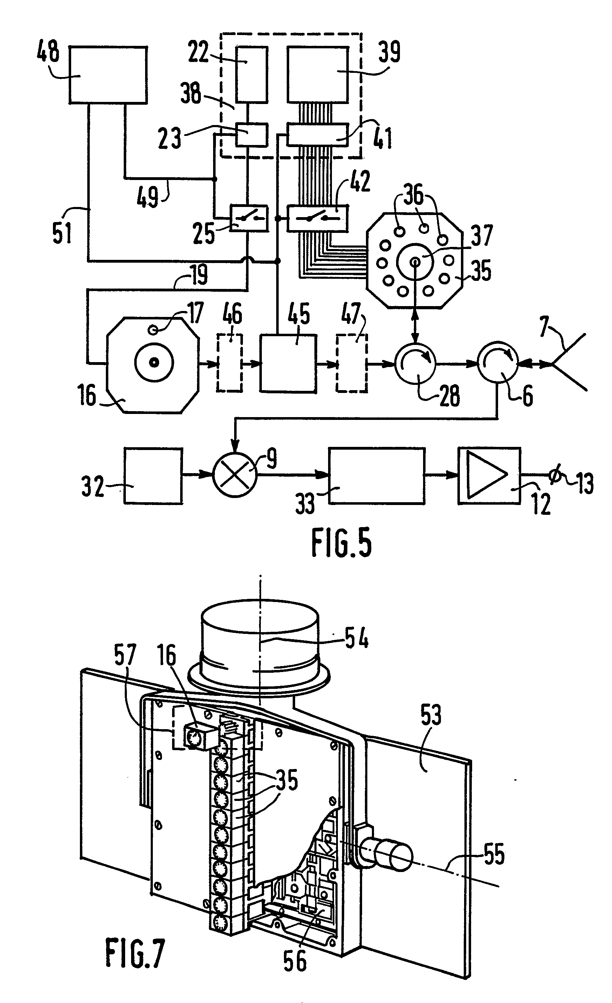

La figure 4 représente un radar semblable à celui de la figure 3, dans lequel la source de puissance est constituée par un combineur à diodes Impatt circulaire 35. Le combineur 35 est semblable au combineur 16 à cela près qu'il comporte 10 diodes Impatt 36 et qu'il est synchronisé, à partir de sa cavité 37 par le signal de sortie du combineur 16 qui a traversé une partie du circulateur 28. Le circuit d'alimentation 38 qui comporte les éléments 22 et 23 comporte aussi un générateur de tension 39 et un modulateur 41, et des interrupteurs 42 sont disposés en série sur les conducteurs d'alimentation des diodes Impatt 36. Les diodes 36 sont alimentées à courant constant et les éléments 39, 41 et 42 sont semblables aux éléments 22, 23 et 25 respectivement. Un circuit d'alimentation séparé pour chaque diode 36 permet de régler le courant de façon indépendante dans chaque diode. S'il y a une dispersion de caractéristiques faible entre les diodes 36 on peut envisager d'en alimenter plusieurs à partir d'un même circuit d'alimentation. Dans le circuit de la figure 4, le même signal d'horloge commande simultanément les interrupteurs 25 et 42 et de façon concomitante les modulateurs 23 et 41.

Les non-linéarités de la courbe C, figure 2b, peuvent être compensées de façon connue, pour les circuits des figures 3 et 4, de manière passive et/ou active. La manière passive consiste à introduire une self de valeur appropriée en série sur le conducteur 19, comme représenté en 43 en trait interrompu sur la figure 4. La manière active, qui permet de réaliser une linéarisation assez fine de la courbe C selon la droite R et qui est à la portée de l'homme du métier, consiste à modifier la valeur de la tension d'alimentation et/ou à ajuster la commande du modulateur 25 pour que ce dernier engendre un courant variable d'un dixième d'ampère environ pendant l'impulsion, selon une courbe d'intensité en fonction du temps favorable à la linéarisation recherchée. Un autre moyen d'améliorer la linéarité de la courbe C, compatible avec ceux qui précèdent, est décrit ci-dessous en référence à la figure 5.

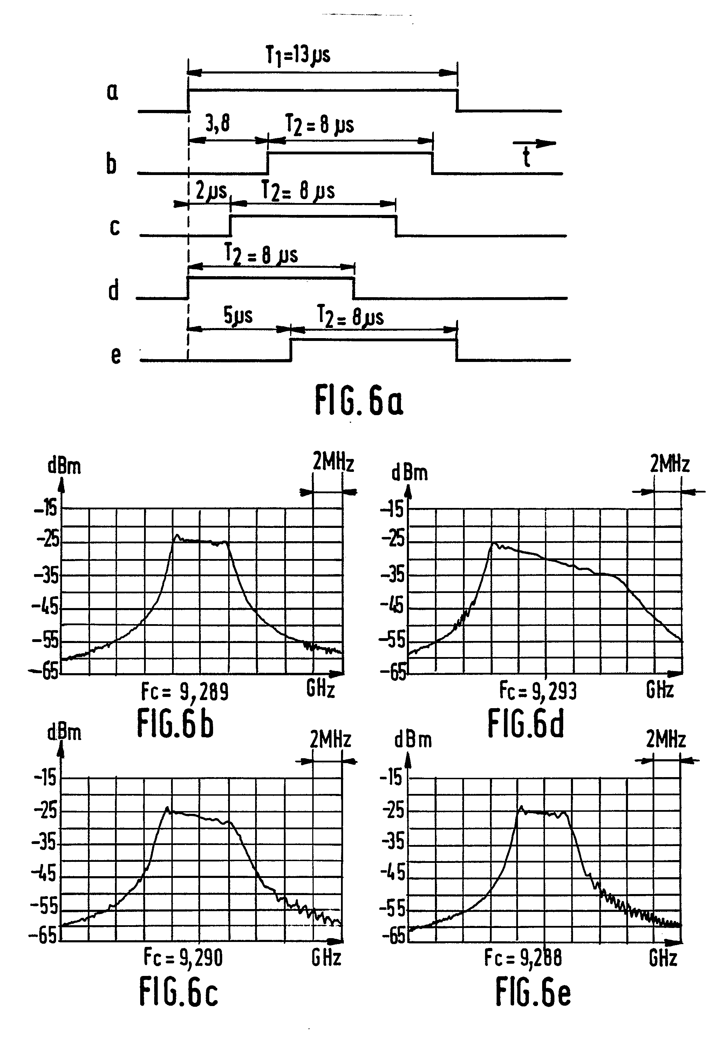

Le circuit de la figure 5 diffère de celui de la figure 4 pour l'essentiel en ce qu'un interrupteur pour hyperfréquences 45 est introduit entre le combineur à une diode 16 et le circulateur 28. De préférence, l'interrupteur 45 est constitué par une diode PIN commandable à partir d'un signal de tension logique, et deux isolateurs 46 et 47 sont agencés de part et d'autre de l'interrupteur 45. Le générateur d'horloge 48 fournit deux signaux de commande d'impulsion. Un premier signal sur un conducteur 49 commande l'interrupteur 25 et le modulateur 23 pour engendrer des impulsions de durée T1 par exemple égale à 13 μs comme représenté à la figure 6a. Un deuxième signal sur un conducteur 51 commande simultanément les interrupteurs 42 et le modulateur 41, c'est-à-dire l'alimentation des diodes Impatt 36, et le commutateur pour hyperfréquences 45 pour engendrer des impulsions utiles de durée T2. Chaque durée de conduction T2 des diodes 36 est comprise dans une durée de conduction T1 correspondante de la diode 17. Il est ainsi possible d'opérer sur la courbe C un effet d'obturateur ou de fenêtre, permettant de sélectionner la partie la plus linéaire de cette courbe. Les résultats obtenus sont indiqués ci-après en référence aux figures 6a à 6e.

Pour les positions b et e de l'impulsion utile : T2 = 8µs, les plus éloignées du début de l'impulsion : T1 = 13µs, figure 6a, on s'approche le plus d'un spectre théorique, voir pour cela les spectres des figures 6b et 6e, la différence par rapport au spectre théorique parfait étant due aux non-linéarités résiduelles de la courbe C, alors que les spectres des figures 6c et 6d montrent clairement l'influence très défavorable de la forte non-linéarité du début de l'impulsion T1. On notera, en examinant les spectres des figures 6b à 6e que les défauts de linéarité ne sont pas des défauts du type de modulations sinusoïdales, pour passer de la rampe R à la courbe C, qui se traduiraient par des spectres nettement dentelés de part et d'autre de la fréquence centrale Fc. Au lieu de cela on observe seulement une légère décroissance de l'amplitude dans le spectre. Ce dernier type de défaut se rapproche d'un défaut du type exponentiel ou quadratique dont l'influence sur l'impulsion comprimée est moins sévère qu'un défaut sinusoïdal et qui se traduit par un élargissement du pic central et une moyenne de l'ensemble des lobes secondaires. Le type de défaut en question peut être partiellement corrigé à partir de l'organe de compression d'impulsions 33, plus précisément à partir du filtre de pondération des lobes secondaires, généralement intégré à l'organe 33.

Dans le radar de la figure 5, un combineur à diodes 35 ayant une puissance de sortie de 100 W crête environ est synchronisé par un signal d'entrée dans la cavité 37, de l'ordre de 7 W. On sait que dans le cas d'oscillateurs synchronisés (injection-locking oscillators en langue anglaise), la bande de synchronisation maximale dF se déduit en première approximation de la relation :

$$dF = \frac{2Fc}{QL} \left(\frac{Pe}{Ps}\right)^{1/2} \qquad (1)$$

où :
Pe : puissance d'entrée (7 W)
Ps : puissance de sortie (100 W)
QL = 100
Fc : fréquence centrale (9290 MHz)
soit :
dF = 49 MHz.

Or, la plage de variation de fréquence dans l'impulsion envisagée, visible sur les figures 6b à 6e n'est que de l'ordre de 4 MHz (typiquement 3,6 MHz). La relation (1) ci-dessus indique que pour une puissance du signal de synchronisation égale à 7 W, il est possible d'augmenter la puissance du radar de la figure 5 sans modifier la structure fondamentale du circuit. Il suffit pour cela d'augmenter la puissance de la source de puissance, de façon non représentée, par exemple en augmentant le nombre de diodes Impatt du combineur 35 (16 diodes au lieu de 10) et/ou en agençant en parallèle deux ou trois combineurs à diodes 35 synchronisés à partir du même signal en provenance du circulateur 28. Il est ainsi possible d'obtenir un radar à compression d'impulsions selon le circuit de la figure 4 ou de la figure 5 ayant une puissance de 300 W crête environ.

Selon une autre forme d'exécution de l'invention, non représentée sur les schémas synoptiques, il est aussi possible d'augmenter de façon connue la puissance du radar des figures 4 et 5 en ajoutant un étage de puissance supplémentaire, ce qui consiste à rajouter entre les circulateurs 28 et 6 un troisième circulateur relié à plusieurs combineurs à diodes tels que 35 (environ 10 combineurs) qui reçoivent en parallèle le signal de sortie du circulateur 28 en tant que signal de synchronisation. Ceci permet d'obtenir un radar à compression d'impulsions selon l'invention ayant une puissance de l'ordre de 1 kW crête.

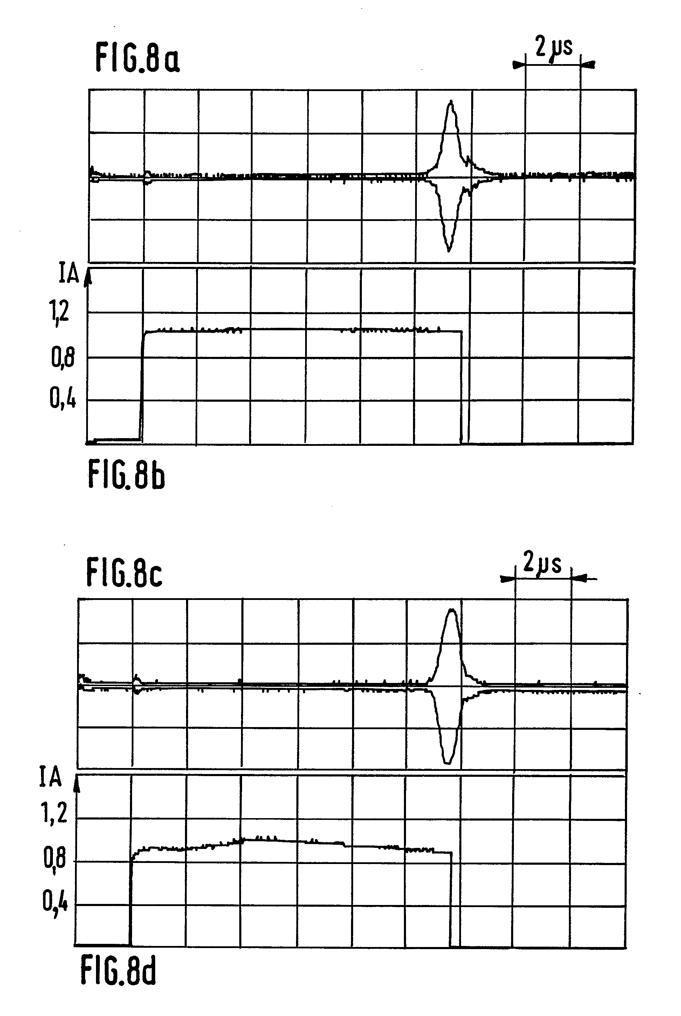

La génération du signal de synchronisation de la source de puissance directement en hyperfréquences permet, en disposant les parties hautes fréquences des chaînes d'émission et de réception du radar derrière une antenne à fentes, de réaliser un ensemble : antenne-émission-réception compact et léger, comme représenté à la figure 7.

Sur la figure 7, la référence 53 désigne une antenne à fentes supportant à sa partie arrière l'ensemble des parties hautes fréquences des chaînes d'émission et de réception du radar. Les axes de pivotement en gisement et en élévation de l'ensemble sont référencés respectivement 54 et 55. Le circuit représenté, fournissant une puissance de 1 kW environ, comporte le combineur à une diode 16 et 11 combineurs à diodes 35. Les circuits micro-électroniques 56 fonctionnant en hyperfréquences ainsi que les modulateurs sont réalisés de préférence selon la technologie des circuits hybrides.

Si le radar est conçu pour fonctionner dans des conditions sévères de température, cette dernière pouvant varier de -40°C à +85°C par exemple, il est avantageux, selon une variante de l'invention, de placer au moins le combineur à une diode 16 dans une enceinte thermostatée telle que représentée symboliquement par le trait interrompu 57 sur la figure 7.

Les principales applications visées pour le radar à compression selon l'invention sont son application à la météorologie et/ou à la cartographie, le radar étant disposé au sol ou aéroporté. Pour des puissances de l'ordre du kW on peut envisager une application à la surveillance maritime. D'une façon générale, les applications sont celles des radars à compression d'impulsions.

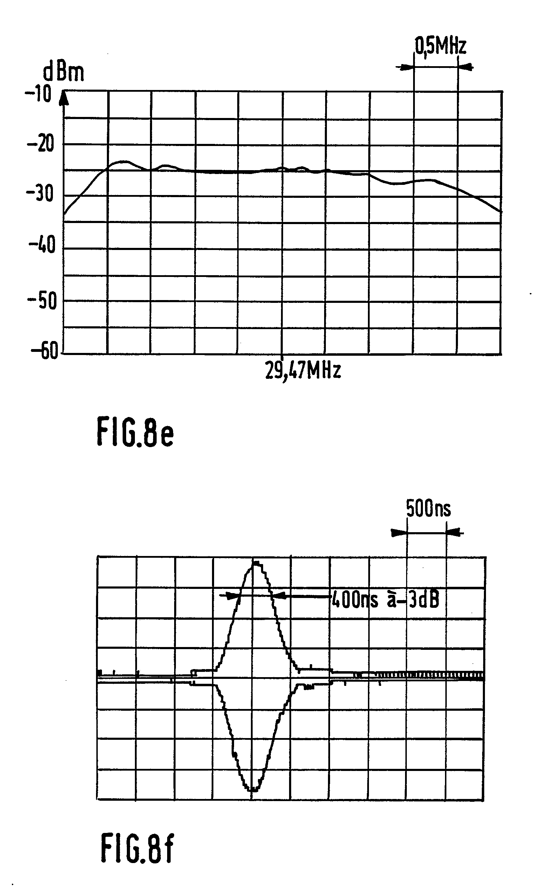

Des résultats obtenus en utilisant une diode Impatt 17 de la société MACOM et une ligne 33 de la société ANDERSEN LABORATORIES précisées ci-dessus, sont indiqués aux figures 8a à 8f où les abscisses et les ordonnées sont en échelle linéaire. La figure 8a représente la forme du signal sur la borne de sortie 13 du radar, pour le mode de réalisation de la figure 5, avec un courant modulateur constant dans la diode Impatt 17, représenté à la figure 8b. On observe, sur l'impulsion comprimée de la figure 8a des lobes secondaires d'un niveau élevé. Sur les figures 8c et 8d analogues aux figures 8a et 8b respectivement, toujours pour le mode de réalisation de la figure 5, le courant modulateur subit une variation d'amplitude globale de 0,1 A environ, figure 8d, et les lobes secondaires de l'impulsion comprimée, figure 8c, sont nettement atténués. Les figures 8e et 8f se rapportent au circuit de la figure 5 dans lequel à la fois la position de la fenêtre de découpage de l'impulsion T1 par l'impulsion T2 et la valeur du courant modulateur dans la diode Impatt 17 ont été optimisés. Le spectre de l'impulsion utile T2 avant compression est représenté à la figure 8e et, sur la représentation de l'impulsion comprimée de la figure 8f, on constate que les lobes secondaires sont ramenés à -20 dB par rapport au lobe principal.

## Revendications

1. Radar à compression d'impulsions du type à modulation quasi-linéaire de la fréquence du signal émis pendant l'impulsion, comportant une chaîne d'émission munie d'un oscillateur-amplificateur à haute fréquence, une antenne émettrice-réceptrice et une chaîne de réception munie d'un organe de compression d'impulsions, caractérisé en ce que dans la chaîne d'émission une diode Impatt d'un combiner à une diode engendre directement en hyperfréquence un signal de synchronisation dudit oscillateur-amplificateur consistant en des impulsions modulées selon des rampes négatives de fréquence, qu'un circuit d'alimentation alimente ladite diode Impatt sous un courant sensiblement constant et qu'un générateur d'horloges commande, pour la génération de chaque impulsion d'émission successivement la fermeture puis l'ouverture d'un interrupteur disposé en série sur le conducteur d'alimentation de ladite diode Impatt.

2. Radar à compression d'impulsions selon la revendication 1, caractérisé en ce que ledit circuit d'alimentation comporte un modulateur de courant réglé pour engendrer dans ladite diode Impatt, pendant la durée de l'impulsion, un courant modulé qui compense au moins au premier ordre les défauts de linéarité dudit signal de synchronisation.

3. Radar à compression d'impulsions selon la revendication 1 ou 2 comportant un oscillateur-amplificateur à haute fréquence constitué par un combiner à diodes dont chaque diode est alimentée par un circuit d'alimentation à courant constant pendant l'impulsion, issu d'un modulateur, et dans lequel des interrupteurs sont disposée en série sur les conducteurs d'alimentation des diodes dudit combiner à diodes.

4. Radar à compression d'impulsions selon la revendication 3, caractérisé en ce que le même signal d'horloge commande à la fois l'interrupteur d'alimentation de la diode Impatt dudit combiner à une diode et les interrupteurs d'alimentation des diodes dudit combiner à diodes.

5. Radar à compression d'impulsions selon la revendication3, caractérisé en ce qu'il comporte en outre dans la chaîne d'émission entre ledit combiner à une diode et ledit combiner à diodes un interrupteur pour hyperfréquences qui est commandé en conduction à partir dudit générateur d'horloges ainsi que les interrupteurs d'alimentation des diodes dudit combiner à diodes selon une première durée d'impulsion utile, et que l'interrupteur d'alimentation de la diode Impatt dudit combiner à une diode est commandé en conduction à partir dudit générateur d'horloges selon une deuxième durée qui contient ladite première durée, pour la génération de chaque impulsion d'émission.

6. Radar à compression d'impulsions selon l'une des revendications 1 à 5, caractérisé en ce que les parties à hautes fréquences des chaînes d'émission et de réception dudit radar sont fixées contre la partie arrière d'une antenne d'émission-réception à fentes.

7. Radar à compression d'impulsions selon la revendication 6 dans lequel les circuits micro-électroniques fonctionnant en hyperfréquences ainsi que les modulateurs sont réalisés selon la technologie des circuits hybrides.

8. Radar à compression d'impulsions conçu pour fonctionner dans des conditions sévères de température, selon l'une des revendications 1 à 7, caractérisé en ce qu'au moins ledit combineur à une diode est placé dans une enceinte thermostatée.

9. Application du radar à compression d'impulsions de faible puissance selon l'une des revendications précédentes à la cartographie.

10. Application du radar à compression d'impulsions de faible puissance selon l'une des revendications précédentes à la météorologie.

FIG.1

FIG.2a

FIG.2b

**FIG.3**

**FIG.4**

FIG.5

FIG.7

FIG. 6a

Fc = 9,289

FIG. 6b

Fc = 9,293

FIG. 6d

Fc = 9,290

FIG. 6c

Fc = 9,288

FIG. 6e

FIG.8a

2 µs

IA
1,2
0,8
0,4

FIG.8b

FIG.8c

2 µs

IA
1,2
0,8
0,4

FIG.8d

FIG.8e

0,5MHz

29,47MHz

FIG.8f

500ns

400ns ã−3dB

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | FR-A-2 581 268 (ELECTRONIQUE SERGE DASSAULT) <br> * Résumé; page 10, lignes 12-34; page 12, revendication 1; figures 1,2,6 * <br> --- | 1-3 | G 01 S  13/28 <br> G 01 S   7/28 <br> H 03 B   9/14 |
| Y | IEEE TRANSACTIONS ON MICROWAVE THEORY AND TECHNIQUES, vol. MTT-27, no. 5, mai 1979, pages 492-499, IEEE, New York, US; T.T. FONG et al.: "Millimeter-wave pulsed IMPATT sources" <br> * Pages 495-497, paragraphes IV-VI * <br> --- | 1-3 | |
| A | GB-A-2 116 392 (RAYTHEON) <br> * En entier * <br> --- | 1-5 | |
| A | US-A-4 130 810 (R.M WALLACE) <br> * Résumé; colonne 3, ligne 4 - colonne 4, ligne 3; colonne 12, lignes 22-40; figure 1 * <br> --- | 1,3,8 | |
| A | AGARD ADVISORY GROUP FOR AEROSPACE RESEARCH & DEVELOPMENT, Neuilly Sur Seine, France, Agard Conference Proceedings no. 197, On New Devices, Techniques and Systems in Radar, pages 1-3 - 1-14, North Atlantic Treaty Organization; I.W. MACKINTOSH et al.: "Solid state microwave amplifiers and locked oscillators for coherent radar transmitters" <br> * Pages 1-1 - 1-6 * <br> ---                          -/- | 1 | **DOMAINES TECHNIQUES RECHERCHES (Int. Cl.4)** <br><br> G 01 S <br> H 03 B |

Le présent rapport a été établi pour toutes les revendications

| Lieu de la recherche | Date d'achèvement de la recherche | Examinateur |
|---|---|---|
| LA HAYE | 30-03-1989 | VAN WEEL E.J.G. |

EPO FORM 1503 03.82 (P0402)

Page 2

# RAPPORT DE RECHERCHE EUROPEENNE

Office européen
des brevets

Numero de la demande

EP 88 20 2947

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | 1981 IEEE MTT-S INTERNATIONAL MICROWAVE SYMPOSIUM DIGEST, Digest éditeur J.E. RAUE, pages 414-416, IEEE, New York, US; T. KIHM et al.: "A W-band, coherent, pulse-compression radar transceiver using linear frequency modulation" <br> * En entier * | 1 | |

<br>

**DOMAINES TECHNIQUES RECHERCHES (Int. Cl.4)**

Le présent rapport a été établi pour toutes les revendications

| Lieu de la recherche | Date d'achèvement de la recherche | Examinateur |
|---|---|---|
| LA HAYE | 30-03-1989 | VAN WEEL E.J.G. |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
.......................................................................
& : membre de la même famille, document correspondant

EPO FORM 1503 03.82 (P0402)